# EUROPÄISCHE PATENTSCHRIFT

(11) **EP 0 925 622 B1**
(45) Veröffentlichungstag und Bekanntmachung des Hinweises auf die Patenterteilung: **29.01.2003**
(21) Anmeldenummer: 98942487.4
(22) Anmeldetag: 02.07.1998
(51) Int. Cl.: H01R 33/09, H01K 1/46

(54) **KLEINGLÜHLAMPE**
MINIATURE FILAMENT LAMP
LAMPE A INCANDESCENCE MINIATURE

(30) Priorität: 04.07.1997 DE 19728625
(43) Veröffentlichungstag der Anmeldung: 30.06.1999
(73) Patentinhaber: Patent-Treuhand-Gesellschaft für elektrische Glühlampen mbH, 81543 München (DE)
(72) Erfinder: HELBIG, Peter, D-89567 Sontheim (DE); STEINER, Hermann, D-89542 Herbrechtingen (DE)
(86) Internationale Anmeldenummer: DE9801830
(87) Internationale Veröffentlichungsnummer: WO99001913

(56) Entgegenhaltungen:
- EP-A- 0 139 510
- GB-A- 1 236 261
- GB-A- 1 247 850
- US-A- 3 648 044
- US-A- 4 181 390
- US-A- 5 209 668

## Beschreibung

Die Erfindung betrifft eine Kleinglühlampe gemäß dem Oberbegriff des Patentanspruches 1.

### I. Stand der Technik

Eine derartige Kleinglühlampe ist beispielsweise in dem deutschen Gebrauchsmuster G 296 10 849.9 offenbart. Die in dieser Druckschrift beschriebene Kleinglühlampe ist zur Montage auf einer Leiterplatine vorgesehen und besitzt einen Sockel mit zwei U-förmigen elektrischen Sockelkontakten, einem im Sockel fixierten zylindrischen Lampenkolben und zwei aus dem Lampenkolben herausgeführte Stromzuführungen, die mit jeweils einem U-förmigen Sockelkontakt elektrisch leitend verbunden sind. Die U-förmigen Sockelkontakte weisen jeweils eine ebene Kontaktfläche auf.

Die Patentschrift US 4,181,390 beschreibt Fassungskontakte für eine mit einem Glassockel versehene Kleinglühlampe.

### II. Darstellung der Erfindung

Es ist die Aufgabe der Erfindung, eine Kleinglühlampe mit verbesserten Sockelkontakten bereitzustellen.

Diese Aufgabe wird erfindungsgemäß durch die kennzeichnenden Merkmale des Patentanspruchs 1 gelöst. Besonders vorteilhafte Ausführungen der Erfindung sind in den Unteransprüchen beschrieben.

Die Kleinglühlampe besitzt zwei, jeweils mit einer ebenen Kontaktfläche ausgestattete elektrische Sockelkontakte.

Erfindungsgemäß weist jeder Sockelkontakt einen angeformten, von der ebenen Kontaktfläche abgewinkelten, zangenförmig ausgebildeten Abschnitt auf. Der zangenförmige Abschnitt gewährleistet eine sichere Verankerung des Sockelkontaktes im Lampensockel. Außerdem ist jeder Sockelkontakt mit einem angeformten hakenförmigen Abschnitt ausgestattet, in den jeweils eine der Stromzuführungen eingelegt und elektrisch leitend befestigt ist. Die hakenförmigen Abschnitte der Sockelkontakte erlauben eine sichere Befestigung und Kontaktierung der aus dem Lampenkolben herausgeführten Stromzuführungen an den Sockelkontakten. Die Sockelkontakte sind jeweils einteilig ausgebildet. Der hakenförmige Abschnitt des Sockelkontaktes ist an den zangenförmig ausgebildeten Abschnitt des Sockelkontaktes angeformt. Die erfindungsgemäße Kleinglühlampe besitzt eine ebene Bodenfläche, in die die ebenen Kontaktflächen der Sockelkontakte angeordnet sind. Dadurch wird die Leiterplatinenmontage der erfindungsgemäßen Kleinglühlampe erleichtert.

### III. Beschreibung des bevorzugten Ausführungsbeispiels

Nachstehend wird. die Erfindung anhand eines bevorzugten Ausführungsbeispiels näher erläutert. Es zeigen:
- Figur 1: eine Seitenansicht der Kleinglühlampe gemäß des bevorzugten Ausführungsbeispiels
- Figur 2: die Oberseite der in Figur 1 abgebildeten Kleinglühlampe
- Figur 3: die Unterseite der in Figur 1 abgebildeten Kleinglühlampe

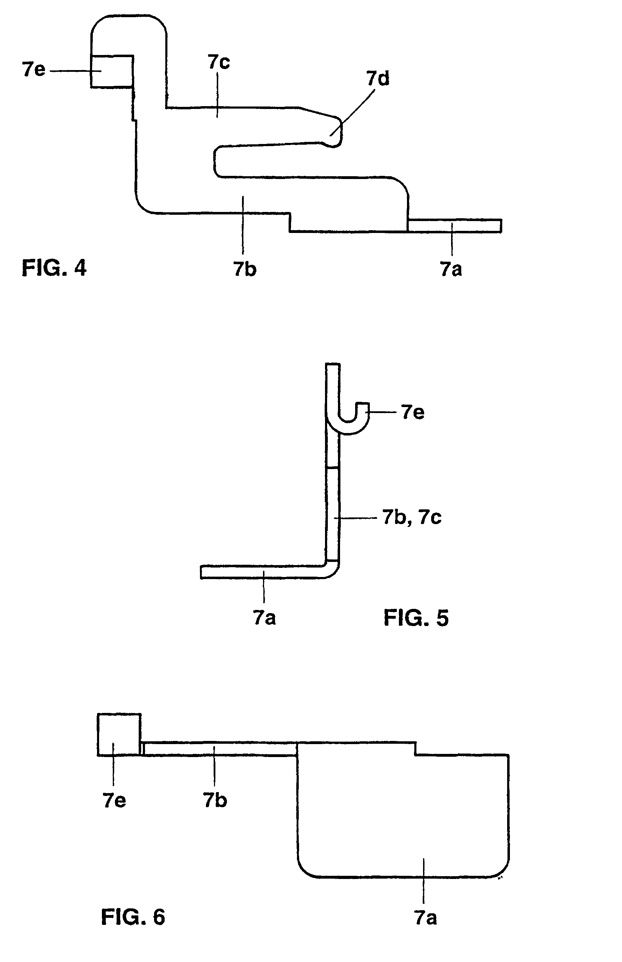

- Figur 4: eine Seitenansicht eines Sockelkontaktes der in Figur 1 abgebildeten Kleinglühlampe
- Figur 5: die Vorderseite des in Figur 4 abgebildeten Sockelkontaktes
- Figur 6: die Unterseite des in Figur 4 abgebildeten Sockelkontaktes

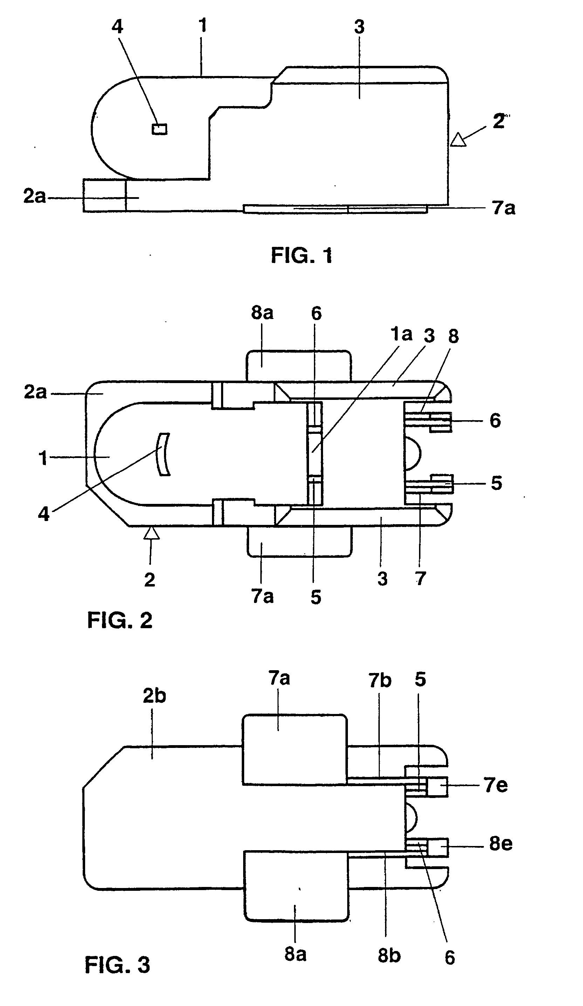

Die in den Figuren 1 bis 3 schematisch dargestellte Kleinglühlampe gemäß des bevorzugten Ausführungsbeispiels besitzt einen gläsernen, im wesentlichen zylindrischen und mittels eines Quetschfußes 1a abgedichteten Lampenkolben 1 und einen Sockel 2 aus Kunststoff. Der Lampenkolben 1 ist liegend in einer Aufnahme des Lampensockels 2 angeordnet. Der Lampensockel 2 besitzt einen Boden 2a mit einer ebenen Bodenfläche 2b und zwei Seitenwände 3, die den Lampenkolben 1 in seiner Lage von drei Seiten abstützen. Im Innenraum des Lampenkolbens 1 befindet sich eine Glühwendel 4, die durch zwei aus dem Lampenkolben 2 herausgeführte Stromzuführungen 5, 6 und durch zwei metallische Sockelkontakte 7, 8 mit elektrischer Energie versorgt wird.

Die beiden Sockelkontakte 7, 8 weisen jeweils eine ebene, rechteckige Kontaktfläche 7a, 7b auf, die in der Bodenfläche 2b des Sockelbodens 2a angeordnet sind und die zum Auflöten der Kleinglühlampe auf eine Leiterplatine (nicht abgebildet) dienen. Außerdem besitzt jeder Sockelkontakt 7, 8 einen zangenförmig ausgebildeten Abschnitt 7b, 7c, 8b, 8c, dessen unterer Schenkel 7b, 8b an die Kontaktfläche 7a, 8a angeformt und von dieser rechtwinklig abgewinkelt ist. Der zangenförmige Abschnitt 7b, 7c, 8b, 8c dient zur Verankerung des Sokkelkontaktes 7, 8 im Lampensockel 2. An dem oberen Schenkel 7c, 8c des zangenförmigen Abschnittes 7b, 7c, 8b, 8c ist außerdem eine Rastnase 7d angebracht. Ferner weisen die Sockelkontakte 7, 8 jeweils einen hakenförmigen Abschnitt 7e, 8e auf, der an den oberen Schenkel 7c, 8c des jeweiligen Sockelkontaktes 7, 8 angeformt ist: In die hakenförmigen Abschnitte 7e, 8e der Sockelkontakte 7, 8 ist jeweils ein Ende der Stromzuführungen 5, 6 eingelegt und mit dem entsprechenden hakenförmigen Abschnitt 7e, 8e verschweißt. Die beiden metallischen Sockelkontakte 7, 8 sind spiegelsymmetrisch zu beiden Seiten des Lampenkolbens 1 angeordnet.

## Patentansprüche

1. Kleinglühlampe zur Montage auf einer Leiterplatine mit
- einem Sockel (2) mit zwei elektrischen Sockelkontakten (7, 8), wobei die Sockelkontakte (7, 8) jeweils eine ebene, für die Leiterplatinenmontage zugängliche Kontaktfläche (7a, 8a) besitzen,
- einem am Sockel (2) fixierten Lampenkolben (1) mit darin angeordnetem Leuchtmittel (4),
- zwei aus dem Lampenkolben (1) herausgeführten Stromzuführungen (5, 6) für das Leuchtmittel (4), wobei die Stromzuführungen (5, 6) jeweils mit einem der elektrischen Sockelkontakte (7, 8) elektrisch leitend verbunden sind, wobei
- jeder elektrische Sockelkontakt (7, 8) einen angeformten, von seiner ebenen Kontaktfläche (7a, 8a) abgewinkelten und zangenförmig ausgebildeten Abschnitt (7b, 7c, 8b, 8c) aufweist,
- der Sockel (2) eine ebene Bodenfläche (2b) besitzt, wobei die ebenen Kontaktflächen (7a, 8a) der elektrischen Sockelkontakte (7, 8) in der ebenen Bodenfläche (2b) des Sockels (2) angeordnet sind und zum Auflöten der Kleinglühlampe auf eine Leiterplatine dienen,
**dadurch gekennzeichnet, dass**
- die zangenförmig ausgebildeten Abschnitte (7b, 7c, 8b, 8c) zur Verankerung der Sockelkontakte (7, 8) im Sockel (2) dienen,
- jeder Sockelkontakt (7, 8) einen hakenförmigen Abschnitt (7e, 8e) aufweist, in den jeweils eine der Stromzuführungen (5, 6) eingelegt und verschweißt ist.

## Claims

1. Miniature incandescent lamp for mounting on a printed circuit board, having
- a base (2) with two electric base contacts (7, 8), the base contacts (7, 8) in each case having a plane contact surface (7a, 8a) accessible for mounting on a printed circuit board,
- a lamp bulb (1) fixed to the base (2) and with a luminous means (4) arranged therein,
- two supply leads (5, 6), guided out of the lamp bulb (1), for the luminous means (4), the supply leads (5, 6) being connected in each case in an electrically conducting fashion to one of the electric base contacts (7, 8),
wherein
- each electric base contact (7, 8) has an integrally formed section (7b, 7c, 8b, 8c) which is angled off from its plane contact surface (7a, 8a) and constructed like tongs, and
- the base (2) has a plane bottom surface (2b), the plane contact surfaces (7a, 8a) of the electric base contacts (7, 8) being arranged in the plane bottom surface (2b) of the base (2) and being used for soldering the minature incandescent lamp onto a printed circuit board
**characterized in that**
- the sections (7b,7c,8b,8c) constructed like tongs are used for anchoring the base contacts (7,8) in the base (2), and
- each base contact (7,8) has a hook-shaped section (7e,8e) into each of which one of the supply leads (5,6) is inserted and welded.

## Revendications

1. Lampe à incandescence miniature destinée à être montée sur une plaquette à circuit imprimé comprenant
- un culot (2) ayant deux contacts (7, 8) électriques de culot, les contacts (7, 8) de culot ayant respectivement une surface (7a, 8a) plane de contact accessible pour le montage sur une plaquette à circuit imprimé,
- une ampoule (1) de lampe immobilisée dans le culot (2) et ayant à l'intérieur un agent (4) lumineux,
- deux entrées (5, 6) de courant pour l'agent (4) lumineux, qui sont sorties de l'ampoule (1) de la lampe et qui sont reliées d'une manière conductrice de l'électricité respectivement à l'un des contacts (7, 8) électriques du culot, dans laquelle
- chaque contact (7, 8) électrique de culot a une partie (7b, 7c, 8b, 8c) qui en est issue d'un seul tenant, qui est coudée par rapport à sa surface (7a, 8a) plane de contact et qui est en forme de pince,
- le culot a une surface (2) de fond, des surfaces (7a, 8a) planes de contact des contacts (7, 8) électriques de culot étant disposées dans la surface (2b) plane de fond du culot (2) et servant à braser la lampe à incandescence miniature sur une plaquette à circuit imprimé,
**caractérisée en ce que**
- les parties (7b, 7c, 8b, 8c) constituées sous forme de pince servent à ancrer les contacts (7, 8) de culot dans le culot (2),
- chaque contact (7, 8) de culot a une partie (7e, 8e) en forme de crochet, dans laquelle respectivement l'une des entrées (5, 6) de courant est introduite et est soudée.
